# EUROPÄISCHE PATENTSCHRIFT

(11) **EP 2 791 949 B1**
(45) Veröffentlichungstag und Bekanntmachung des Hinweises auf die Patenterteilung: **30.11.2022**
(21) Anmeldenummer: 12778650.7
(22) Anmeldetag: 02.10.2012
(51) Int. Cl.: H01C 1/142, H01C 7/18, H01G 4/232, H01G 4/30

(54) **ELEKTRISCHES BAUELEMENT UND VERFAHREN ZUR HERSTELLUNG EINES ELEKTRISCHEN BAUELEMENTS**
ELECTRICAL COMPONENT AND METHOD FOR PRODUCING AN ELECTRICAL COMPONENT
COMPOSANT ÉLECTRIQUE ET PROCÉDÉ DE FABRICATION D'UN COMPOSANT ÉLECTRIQUE

(30) Priorität: 16.12.2011 DE 102011056515
(43) Veröffentlichungstag der Anmeldung: 22.10.2014
(73) Patentinhaber: TDK Electronics AG, 81671 München (DE)
(72) Erfinder: FEICHTINGER, Thomas, 8010 Graz (AT); LAUENSTEIN, Jörg, 8530 Deutschlandsberg (AT)
(74) Vertreter: Epping - Hermann - Fischer
(86) Internationale Anmeldenummer: PCT/EP2012/069431
(87) Internationale Veröffentlichungsnummer: WO 2013/087243

(56) Entgegenhaltungen:
- EP-A1- 2 034 496
- DE-A1- 3 528 077
- DE-A1-102007 007 113

## Beschreibung

Es wird ein elektrisches Bauelement angegeben. Weiterhin wird ein Verfahren zur Herstellung eines elektrischen Bauelements angegeben.

Bei elektrischen Bauelementen, die als so genannte oberflächenmontierbare Bauelemente (SMD-Bauelement, "surface mounted device") ausgeführt sind, treten bei der Oberflächenmontage durch das übliche Reflow-Löten an der Schnittstelle zwischen Außenterminierung und Grundkörper der Bauelemente bei unterschiedlichen thermischen Ausdehnungskoeffizienten von Metallen und Keramiken beziehungsweise Metallen und Halbleitermaterialien thermische Spannungen auf. Diese thermischen Spannungen können beispielsweise zu Risskeimen und in weiterer Folge zu Zuverlässigkeitsproblemen der elektrischen Bauelemente führen. Insbesondere elektrische Bauelemente, die mit einer glashaltigen Passivierung umhüllt sind und einen Keramik- oder Siliziumkörper aufweisen, sind für derartige Risse anfällig. Die thermischen Spannungen verstärken sich weiterhin insbesondere bei elektrischen Bauelementen, welche eine relativ große SMD-Bauform aufweisen, beispielsweise eine Bauform 1210 oder größer.

Die DE 10 2007 007 113 A1 beschreibt ein VielschichtBauelement aufweisend einen Körper, der von einer glashaltigen, elektrisch isolierenden Passivierungsschicht bedeckt ist.

Die EP 2 034 496 A1 beschreibt einen keramisches Bauelement, bei dem eine Außenelektrode eine Dickfilmschicht aufweist, die von einer elektrisch leitenden Harzschicht bedeckt ist.

Es ist eine zu lösende Aufgabe zumindest einiger Ausführungsformen, ein elektrisches Bauelement anzugeben, bei dem thermische Spannungen innerhalb des Bauelements reduziert werden können. Eine weitere Aufgabe zumindest einiger Ausführungsformen ist es, ein Verfahren zur Herstellung eines elektrischen Bauelements anzugeben.

Diese Aufgaben werden durch ein elektrisches Bauelement und ein Verfahren gemäß den unabhängigen Patentansprüchen gelöst.

Die Erfindung wird durch diese unabhängigen Ansprüche definiert.

Vorteilhafte Ausführungsformen und Weiterbildungen der Gegenstände gehen weiterhin aus den abhängigen Patentansprüchen, der nachfolgenden Beschreibung und aus den Zeichnungen hervor.

Das elektrische Bauelement gemäß der Erfindung weist einen Grundkörper auf. Beispielsweise kann der Grundkörper ein Keramikmaterial oder ein Halbleitermaterial aufweisen. Insbesondere kann der Grundkörper beispielsweise durch Versintern hergestellt sein. Beispielsweise kann das elektrische Bauelement als Varistor, Kondensator, Thermistor oder TVS-Siliziumdiode (TVS: "transient voltage suppressor") ausgebildet sein. Des Weiteren weist das elektrische Bauelement eine metallische Kontaktstruktur auf, die unmittelbar mit dem Grundkörper in Kontakt steht. Das bedeutet insbesondere, dass die metallische Kontaktstruktur zumindest teilweise im Inneren des Grundkörpers und/oder auf einer Oberfläche des Grundkörpers angeordnet ist. Die metallische Kontaktstruktur dient dazu, den Grundkörper des elektrischen Bauelements oder zumindest einen oder mehrere Bereiche des Grundkörpers direkt zu kontaktieren.

Weiterhin weist das elektrische Bauelement eine elektrisch isolierende Passivierungsschicht auf. Die Passivierungsschicht weist vorzugsweise ein vom Grundkörper verschiedenes Material auf. Die Passivierungsschicht kann unmittelbar auf dem Grundkörper, insbesondere auf einer oder mehreren Oberflächen des Grundkörpers angeordnet sein und somit mit dem Grundkörper in direktem Kontakt stehen. Vorzugsweise umgibt beziehungsweise umhüllt die Passivierungsschicht den Grundkörper des elektrischen Bauelements. Die Passivierungsschicht kann beispielsweise ein Glas und/oder ein keramisches Material aufweisen oder daraus bestehen. Vorteilhafterweise kann die Passivierungsschicht das elektrische Bauelement gegen mechanische und/oder chemische Einflüsse, beispielsweise gegen Korrosion, schützen.

Erfindungsgemäß ist die Passivierungsschicht mit zumindest einer Öffnung versehen. Das kann bedeuten, dass die Passivierungsschicht eine oder mehrere Aussparungen aufweist und dass der Grundkörper in diesem Bereich oder diesen Bereichen nicht von der Passivierungsschicht bedeckt ist. Vorzugsweise bedeckt die Passivierungsschicht bis auf die zumindest eine Öffnung die gesamte Oberfläche des Grundkörpers.

Erfindungsgemäß ist die metallische Kontaktstruktur durch die zumindest eine Öffnung hindurch mit einer Außenkontaktierung verbunden. Vorzugsweise ist die metallische Kontaktstruktur unmittelbar mit der Außenkontaktierung verbunden. Die Außenkontaktierung kann somit zumindest mit einem Teilbereich direkt auf der metallischen Kontaktstruktur angeordnet sein. Beispielsweise kann die Außenkontaktierung zusätzlich auch auf der Passivierungsschicht angeordnet sein.

Die Außenkontaktierung weist vorzugsweise ein Metall, beispielsweise Silber oder Kupfer, auf. Weiterhin kann die Außenkontaktierung zusätzlich auch Glas aufweisen, beispielsweise zu einem Anteil von 1% bis 5%. Dadurch kann eine gute Versinterung der Außenkontaktierung mit dem Grundkörper beziehungsweise mit der Passivierungsschicht erreicht werden. Die Außenkontaktierung kann zum Beispiel ein auf den Grundkörper und/oder auf die Passivierungsschicht aufgebrachtes Metallpad oder eine eingebrannte Metallpaste sein. Vorzugsweise hat die Außenkontaktierung keinen unmittelbaren Kontakt zum Grundkörper, das heißt die Außenkontaktierung steht vorzugsweise mit dem Grundkörper nicht in direkter Berührung. Über die Außenkontaktierung kann die metallische Kontaktstruktur von außen elektrisch kontaktiert werden.

Erfindungsgemäß ist die Außenkontaktierung von einer flexiblen Metallkompositschicht bedeckt und umschlossen. Die flexible Metallkompositschicht kann beispielsweise alle diejenigen Oberflächen der Außenkontaktierung bedecken, die nicht in unmittelbarer Berührung mit der metallischen Kontaktstruktur oder der Passivierungsschicht stehen. Insbesondere ist die flexible Metallkompositschicht elektrisch leitend ausgebildet. Die flexible Metallkompositschicht weist vorzugsweise ein Kunststoffmaterial, beispielsweise ein Polymer, auf. Die flexible Metallkompositschicht kann auch ein Epoxidharz aufweisen. Weiterhin weist die flexible Metallkompositschicht vorzugsweise ein Metall, wie zum Beispiel Kupfer oder Silber, auf. Beispielsweise kann das Kunststoffmaterial von dem Metall, das beispielsweise in Form von Partikeln vorliegen kann, durchsetzt sein. Es ist auch möglich, dass es sich bei der flexiblen Metallkompositschicht um ein dotiertes Polymer handelt. Mittels der flexiblen Metallkompositschicht kann die metallische Kontaktstruktur über die Außenkontaktierung von außen elektrisch kontaktiert werden.

Mittels des hier beschriebenen Designs des elektrischen Bauelements kann zum einen eine zuverlässige Durchkontaktierung der metallischen Kontaktstruktur mit der Außenkontaktierung durch die Passivierungsschicht hindurch gewährleistet werden. Weiterhin werden durch die flexible Metallkompositschicht Spannungen, die von einer Platine oder Leiterplatte über ein Lot auf das elektrische Bauelement übertragen werden, reduziert, wodurch Risse bei Biegelast und thermodynamischer Wechsellast verhindert werden können.

Gemäß einer weiteren Ausführungsform ist die Außenkontaktierung zumindest teilweise auf der Passivierungsschicht aufgebracht. Beispielsweise steht die Außenkontaktierung dabei in direktem Kontakt mit Teilbereichen der Passivierungsschicht. Diese Teilbereiche grenzen vorzugsweise an die zumindest eine Öffnung der Passivierungsschicht an. Zum Beispiel ist die Außenkontaktierung derart auf der Passivierungsschicht angeordnet, dass die zumindest eine Öffnung der Passivierungsschicht auf der dem Grundkörper abgewandten Seite vollständig von der Außenkontaktierung bedeckt wird.

Gemäß einer weiteren Ausführungsform ist die Außenkontaktierung in der zumindest einen Öffnung angeordnet. Beispielsweise kann die Außenkontaktierung in der Aussparung, die nicht von der Passivierungsschicht bedeckt ist, angeordnet sein, wobei die Passivierungsschicht die Außenkontaktierung begrenzt. Dabei kann die zumindest eine Öffnung vollständig von der Außenkontaktierung ausgefüllt sein.

Gemäß einer weiteren Ausführungsform steht die flexible Metallkompositschicht in direktem Kontakt mit Teilbereichen der Passivierungsschicht. Die flexible Metallkompositschicht bedeckt Teilbereiche der Passivierungsschicht Zum Beispiel kann die flexible Metallkompositschicht kantenübergreifend mehrere Seitenflächen des elektrischen Bauelements zumindest teilweise bedecken. Insbesondere ist es vorteilhaft, wenn die flexible Metallkompositschicht die Passivierungsschicht dort bedeckt, wo das elektrische Bauelement mit einem Träger oder mit einem weiteren elektrischen Bauelement verbunden wird. Gemäß einer weiteren Ausführungsform ragt die metallische Kontaktstruktur in den Grundkörper hinein. Beispielsweise weist die metallische Kontaktstruktur zumindest eine Innenelektrode auf. Es ist auch möglich, dass die metallische Kontaktstruktur mehrere Innenelektroden aufweist. Die eine oder mehrere Innenelektroden dienen der Kontaktierung des Grundkörpers. Im Falle mehrerer Innenelektroden, die durch die Passivierungsschicht hindurch reichen, weist die Passivierungsschicht bevorzugt für jede Innenelektrode eine eigene Öffnung auf. Beispielsweise erstrecken sich die eine oder mehrere Innenelektroden mit ihrem einen Ende durch die eine beziehungsweise mehreren Öffnungen der Passivierungsschicht hindurch bis zu der auf der Passivierungsschicht und auf der Öffnung beziehungsweise den Öffnungen angeordneten Außenkontaktierung. Dadurch stehen die eine oder mehreren Innenelektroden mit der Außenkontaktierung in unmittelbarem Kontakt, so dass die elektrische Kontaktierung des elektrischen Bauelements von außen über die flexible Metallkompositschicht, die Außenkontaktierung und die eine oder mehreren Innenelektroden erfolgen kann. Die Innenelektroden weisen beispielsweise ein Metall, wie zum Beispiel Silber-Palladium, Kupfer oder Nickel, auf oder bestehen daraus.

Gemäß einer weiteren Ausführungsform ist die metallische Kontaktstruktur als metallisches Via ausgeführt. Bei dem metallischen Via handelt es sich vorzugsweise um eine mit einem Metall, beispielsweise mit Silber, gefüllte Durchkontaktierung. Weiterhin kann die metallische Kontaktstruktur eine Mehrzahl von Vias aufweisen, die jeweils getrennt voneinander durch eine eigene Öffnung der Passivierungsschicht hindurchreichen. Beispielsweise erstreckt sich das metallische Via mit seinem einen Ende durch die Öffnung der Passivierungsschicht hindurch bis zu der auf der Passivierungsschicht und auf der Öffnung angeordneten Außenkontaktierung und steht mit der Außenkontaktierung in direktem Kontakt. Dadurch kann die elektrische Kontaktierung des elektrischen Bauelements von außen über die Metallkompositschicht, die Außenkontaktierung und das metallische Via erfolgen.

Gemäß einer weiteren Ausführungsform ist die metallische Kontaktstruktur auf einer Oberfläche des Grundkörpers aufgebracht. Beispielsweise kann die metallische Kontaktstruktur als metallische Elektrode oder als Metallpad ausgebildet sein, wobei die metallische Kontaktstruktur in direktem Kontakt mit dem Grundkörper innerhalb der zumindest einen Öffnung der Passivierungsschicht steht. Dabei kann die Außenkontaktierung den Grundkörper über die metallische Kontaktstruktur elektrisch kontaktieren.

Gemäß einer weiteren Ausführungsform ist auf der dem Grundkörper abgewandten Seite der flexiblen Metallkompositschicht eine erste Schutzschicht angeordnet.

Vorzugsweise steht die erste Schutzschicht in direkter Berührung mit der flexiblen Metallkompositschicht. Die erste Schutzschicht kann insbesondere unmittelbar auf alle diejenigen Oberflächenbereiche der flexiblen Metallkompositschicht aufgebracht sein, die nicht mit der Passivierungsschicht und der Außenkontaktierung in Kontakt stehen. Beispielsweise weist die erste Schutzschicht Nickel, Kupfer oder Silber-Palladium auf oder besteht aus zumindest einem oder einer Kombination dieser Materialien. Die erste Schutzschicht kann die flexible Metallkompositschicht vor chemischen und/oder mechanischen Einflüssen schützen und insbesondere als Korrosionsschutz dienen. Weiterhin kann die erste Schutzschicht die Funktion einer Kontaktschicht aufweisen, über die die flexible Metallkompositschicht und in der Folge das elektrische Bauelement elektrisch kontaktiert werden.

Gemäß einer weiteren Ausführungsform ist auf der ersten Schutzschicht eine zweite Schutzschicht angeordnet. Insbesondere für diejenigen Ausführungsformen, in denen die erste Schutzschicht Nickel oder Kupfer aufweist, wird bevorzugt, dass eine zweite Schutzschicht auf der ersten Schutzschicht angeordnet ist. Vorzugsweise wird die zweite Schutzschicht direkt auf die der flexiblen Metallkompositschicht abgewandten Seite der ersten Schutzschicht aufgebracht, so dass die der flexiblen Metallkompositschicht abgewandte Oberfläche vollständig von der zweiten Schutzschicht bedeckt ist. Die zweite Schutzschicht dient als Oxidationsschutz und verhindert ein Oxidieren der ersten Schutzschicht. Beispielsweise kann die zweite Schutzschicht Zinn oder Gold aufweisen oder daraus bestehen. Alternativ kann die zweite Schutzschicht auch ein organisches Material, insbesondere sogenannte OSP-Materialien (OSP: "organic surface protection", organischer Oberflächenschutz) aufweisen oder daraus bestehen. Zum Beispiel kann die zweite Schutzschicht aus einer auf Imidazolen basierenden organischen Lösung, die auf die erste Schutzschicht aufgebracht wird, hergestellt sein.

Das hier beschriebene Design eines elektrischen Bauelements zeichnet sich insbesondere dadurch aus, dass es hohen Zuverlässigkeitsansprüchen beispielsweise hinsichtlich hoher Biegefestigkeit, Temperaturwechselbeständigkeit oder Feuchtetests, wie sie zum Beispiel im Automobilbereich verlangt werden, genügt.

Weiterhin wird ein Verfahren zur Herstellung eines elektrischen Bauelements angegeben. Das dadurch herstellbare oder hergestellte elektrische Bauelement **weist** die Merkmale des Anspruchs auf. Die vorher und im Folgenden beschriebenen Ausführungsformen gelten gleichermaßen für das elektrische Bauelement wie auch für das Verfahren zur Herstellung des elektrischen Bauelements.

Erfindungsgemäß wird ein Grundkörper bereitgestellt, der mit einer metallischen Kontaktstruktur sowie einer elektrisch isolierenden Passivierungsschicht versehen ist. Die metallische Kontaktstruktur kann beispielsweise als Metallpad, als metallisches Via oder als eine oder mehrere metallische Innenelektroden ausgebildet sein. Die elektrisch isolierende Passivierungsschicht weist vorzugsweise ein Glas- oder ein Keramikmaterial auf. Weiterhin wird eine Außenkontaktierung auf den Grundkörper aufgebracht. Die Außenkontaktierung wird beispielsweise als Metallpaste mittels Siebdruck oder alternativ durch Sputtern oder durch einen Tauchprozess (Dip-Prozess) aufgebracht. Vorzugsweise steht nach dem Aufbringen der Außenkontaktierung die Außenkontaktierung mit der metallischen Kontaktstruktur in direktem Kontakt. Weiterhin wird eine flexible Metallkompositschicht auf die Außenkontaktierung und Bereiche der Passivierungsschicht aufgebracht, zum Beispiel in Form einer mit einem Metall versehenen Polymerpaste. Die Metallkompositschicht wird gemäß dem beanspruchten Verfahren mittels Siebdruck oder mittels eines Tauchprozesses aufgebracht, sodass die Außenkontaktierung von der flexiblen Metallkompositschicht bedeckt und umschlossen ist.

Gemäß einer weiteren Ausführungsform wird nach dem Aufbringen der Außenkontaktierung und/oder nach dem Aufbringen der flexiblen Metallkompositschicht eine thermische Behandlung durchgeführt. Die sich an das Aufbringen der Außenkontaktierung anschließende thermische Behandlung kann beispielsweise über einen Zeitraum von etwa 10 Minuten bis etwa 60 Minuten und bei einer Temperatur von etwa 500°C bis etwa 1000°C durchgeführt werden. Die sich an das Aufbringen der flexiblen Metallkompositschicht anschließende thermische Behandlung wird zum Beispiel über einen Zeitraum von etwa 10 Minuten bis etwa 120 Minuten und bei einer Temperatur von etwa 100°C bis etwa 250°C durchgeführt.

Gemäß einer weiteren Ausführungsform wird auf die flexible Metallkompositschicht eine erste Schutzschicht mittels Elektroplattieren oder mittels Sputtern aufgebracht. Die erste Schutzschicht dient dem Schutz der flexiblen Metallkompositschicht vor chemischen und/oder mechanischen Einflüssen und kann beispielsweise Nickel, Kupfer oder Silber-Palladium aufweisen oder daraus bestehen.

Gemäß einer weiteren Ausführungsform wird auf die erste Schutzschicht zumindest eine zweite Schutzschicht mittels Elektroplattieren oder Sputtern aufgebracht. Die zweite Schutzschicht kann beispielsweise Zinn, Gold oder ein OSP-Material aufweisen oder daraus bestehen und soll die erste Schutzschicht vor Oxidation schützen.

Das hier beschriebene Verfahren zur Herstellung eines elektrischen Bauelements zeichnet sich insbesondere dadurch aus, dass es im Vergleich mit bekannten Verfahren ohne großen zusätzlichen Aufwand erfolgen kann.

Weitere Vorteile und vorteilhafte Ausführungsformen des elektrischen Bauelements ergeben sich aus den im Folgenden in Verbindung mit den Figuren 1 bis 5 beschriebenen Ausführungsformen.

Es zeigen:
- Figur 1: einen Ausschnitt eines Querschnittes eines elektrischen Bauelements gemäß einem ersten Ausführungsbeispiel, wobei das elektrische Bauelement als Keramik-Chip ausgebildet ist,
- Figur 2: einen Ausschnitt eines Querschnittes eines elektrischen Bauelements gemäß einem zweiten Ausführungsbeispiel, wobei das elektrische Bauelement als Silizium-TVS-Dioden-Chip ausgebildet ist,
- Figur 3: eine schematische Ansicht eines Ausschnittes eines elektrischen Bauelements gemäß einem dritten Ausführungsbeispiel, wobei das elektrische Bauelement als Keramikkörper mit Via und Ball-Grid-Array-Terminierung ausgebildet ist,
- Figur 4: einen Ausschnitt eines Querschnittes eines elektrischen Bauelements gemäß einem vierten Ausführungsbeispiel, wobei das elektrische Bauelement als Silizium-Chip mit einer Land-Grid-Array-Terminierung ausgebildet ist, und
- Figur 5: eine schematische Darstellung von Verfahren zur Herstellung eines elektrischen Bauelements gemäß weiteren Ausführungsbeispielen.

In den Ausführungsbeispielen und Figuren können gleiche oder gleich wirkende Bestandteile jeweils mit den gleichen Bezugszeichen versehen sein. Die dargestellten Elemente und deren Größenverhältnisse untereinander sind grundsätzlich nicht als maßstabsgerecht anzusehen. Vielmehr können einzelne Elemente wie zum Beispiel Schichten, Bauteile und Bereiche zur besseren Darstellbarkeit und/oder zum besseren Verständnis übertrieben dick oder groß dimensioniert dargestellt sein.

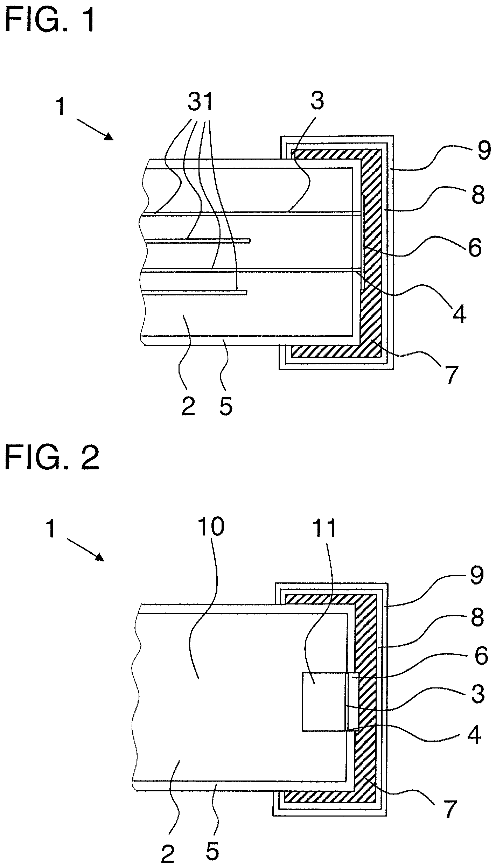

Figur 1 zeigt einen Ausschnitt eines Querschnittes eines elektrischen Bauelements 1 gemäß einem ersten Ausführungsbeispiel. Das elektrische Bauelement 1, das als Keramik-Chip beispielsweise in der dem Fachmann bekannten Bauform 2220 ausgebildet ist, umfasst einen Grundkörper 2, der quaderförmig ausgeführt ist und ein Keramikmaterial aufweist. Alternativ dazu sind auch andere Bauformen möglich. Im gezeigten Ausführungsbeispiel ist das Keramikmaterial eine Varistorkeramik, insbesondere eine ZnO-Bi-Keramik. Alternativ kann es sich bei dem Keramikmaterial auch um eine NTC- oder PTC-Keramik, also um eine Thermistorkeramik, oder um eine dielektrische Kondensatorkeramik handeln, je nachdem ob das elektrische Bauelement 1 als Varistor, als Thermistor oder als Kondensator ausgeführt ist.

Das elektrische Bauelement 1 weist weiterhin eine metallische Kontaktstruktur 3 auf, die mehrere Silber-Palladium aufweisende Innenelektroden 31 umfasst. Alternativ können die Innenelektroden 31 auch andere Metalle, wie zum Beispiel Nickel und/oder Kupfer, aufweisen oder daraus bestehen. Die metallische Kontaktstruktur 3 steht mit dem Grundkörper 2 in unmittelbarem Kontakt, das heißt die metallische Kontaktstruktur 3 befindet sich mit dem Grundkörper 2 in direkter Berührung. Beispielsweise handelt es sich bei dem elektrischen Bauelement 1 um ein keramisches Vielschichtbauelement, bei dem die Innenelektroden 31 auf verschiedene Keramikschichten aufgedruckt und mit diesen versintert werden und somit mit dem durch die einzelnen Keramikschichten gebildeten Grundkörper 2 in direktem Kontakt stehen.

Des Weiteren weist das elektrische Bauelement 1 eine elektrisch isolierende Passivierungsschicht 5 aus Glas auf. Alternativ zum gezeigten Ausführungsbeispiel kann die Passivierungsschicht 5 auch ein Keramikmaterial aufweisen oder daraus bestehen, das vorzugsweise unterschiedlich zum Material des Grundkörpers ist. Die elektrisch isolierende Passivierungsschicht 5 ist vorzugsweise unmittelbar auf den Grundkörper 2 aufgebracht. Vorteilhafterweise schützt die Passivierungsschicht 5 das elektrische Bauelement 1 gegen mechanische und/oder chemische Einflüsse. Die Passivierungsschicht 5 weist für die einzelnen Innenelektroden 31, die bis an die Passivierungsschicht 5 heranreichen, jeweils eine Öffnung 4 auf, durch die die Innenelektroden 31 hindurchragen und über die somit die metallische Kontaktstruktur 3 mit einer Außenkontaktierung 6 verbunden ist. Die Außenkontaktierung 6 ist aus einer Metallpaste aus Silber hergestellt, die mittels eines Siebdruck-, eines Eintauch- oder eines Sputterverfahrens auf den mit der Passivierungsschicht 5 versehenen Grundkörper 2 aufgebracht ist. Die Metallpaste kann gemäß einem weiteren Ausführungsbeispiel auch andere Metalle, wie zum Beispiel Kupfer, aufweisen.

Weiterhin bedeckt und umschließt eine flexible Metallkompositschicht 7 die Außenkontaktierung 6. Die flexible Metallkompositschicht 7 ist aus einer Silber-Polymer-Paste hergestellt. Alternativ kann die flexible Metallkompositschicht 7 auch andere mit einem oder mehreren Metallen versetzte Polymere aufweisen oder daraus bestehen. Beispielsweise kann die Metallkompositschicht 7 Metallpartikel unterschiedlicher Form und/oder Größe aufweisen, die im Polymer verteilt sind und über die eine elektrische Leitung stattfinden kann. Mittels der flexiblen Metallkompositschicht 7 kann erreicht werden, dass durch thermodynamischen Stress verursachte Rissbildungen, insbesondere solche die an den Grenzflächen zwischen Grundkörper 2, Passivierungsschicht 5 und Metallkompositschicht 7 auftreten, verhindert beziehungsweise zumindest reduziert werden können. Dadurch können beispielsweise technische Schwierigkeiten, die aufgrund von hohen Temperaturen, zum Beispiel solchen größer als 500°C, im Herstellungsverfahren von passivierten elektrischen Bauelementen, beispielsweise von passivierten Varistoren, auftreten, beseitigt werden können. Derartig hohe Temperaturen können im Herstellungsverfahren beispielsweise für eine Durchkontaktierung der metallischen Kontaktstruktur durch die Passivierungsschicht erforderlich sein.

Auf der dem Grundkörper 2 abgewandten Seite der flexiblen Metallkompositschicht 7 ist eine erste Schutzschicht 8 aus Nickel angeordnet, wobei die erste Schutzschicht 8 unmittelbar auf die flexible Metallkompositschicht 7 aufgebracht ist. Alternativ kann die erste Schutzschicht 8 auch Kupfer oder Silber-Palladium aufweisen oder daraus bestehen. Die erste Schutzschicht 8 schützt die flexible Metallkompositschicht 7 vor chemischen und/oder mechanischen Einflüssen und dient zugleich als Kontaktschicht, über die die flexible Metallkompositschicht 7 kontaktiert wird.

Des Weiteren ist auf der ersten Schutzschicht 8 eine zweite Schutzschicht 9 aus Zinn angeordnet, die als Oxidationsschutz für die erste Schutzschicht 8 wirkt. Die zweite Schutzschicht 9 steht mit der ersten Schutzschicht 8 in direkter Berührung. Weiterhin ist es möglich, dass die zweite Schutzschicht andere oder weitere für den Oxidationsschutz geeignete Materialen, wie zum Beispiel Gold oder sogenannte OSP-Materialien (OSP: "organic surface protection") aufweist oder daraus besteht. Alternativ zum gezeigten Ausführungsbeispiel können auch noch weitere Schutzschichten auf der ersten und/oder zweiten Schutzschicht 8, 9 angeordnet sein.

Bei sogenannten EOL-Biegefestigkeitsprüfungen (EOL: "end of life"), die sich beispielsweise zur Ermittlung der durchschnittlichen Lebensdauer eines elektrischen Bauelements eignen, hat sich gezeigt, dass das im Zusammenhang mit der Figur 1 beschriebene elektrische Bauelement 1 im Vergleich zu bekannten Bauelementen mit einer Passivierungsschicht aber ohne die hier beschriebene Kontaktierung über die Metallkompositschicht besonders gute Ergebnisse erzielt.

In Figur 2 ist ein Ausschnitt eines Querschnittes eines elektrischen Bauelements 1 gemäß einem weiteren Ausführungsbeispiel gezeigt, wobei das elektrische Bauelement 1 rein beispielhaft als Silizium-TVS-Diodenchip (TVS: "transient voltage suppressor") ausgebildet ist und einen Grundkörper 2 umfasst, der ein Halbleitermaterial aufweist und der mit einer elektrisch isolierenden Passivierungsschicht 5 bedeckt ist. Die elektrisch isolierende Passivierungsschicht 5 weist eine Öffnung 4 auf. Insbesondere weist das elektrische Bauelement 1 als Grundkörper 2 mit einem p-dotierten Bereich 10 und einem n⁺-dotierten Bereich 11, das heißt einer eindiffundierten n-Wanne, auf. Das elektrische Bauelement 1 weist weiterhin eine metallische Kontaktstruktur 3 auf, die als Metallpad, beispielsweise als Kupferpad beziehungsweise als Kupferkathode, ausgebildet ist. Die metallische Kontaktstruktur 3 ist in der Öffnung 4 der Passivierungsschicht 5 direkt auf den Grundkörper 2, insbesondere auf den n⁺-dotierten Bereich 10, aufgebracht.

Weiterhin ist eine Außenkontaktierung 6 auf der metallischen Kontaktstruktur 3 angeordnet, so dass die Außenkontaktierung 6 in direktem Kontakt mit der metallischen Kontaktstruktur 3 steht. Im gezeigten Ausführungsbeispiel weist die Außenkontaktierung 6 Kupfer auf. Alternativ kann die Außenkontaktierung 6 auch andere elektrisch leitende Materialien aufweisen. Die Außenkontaktierung 6 ist zumindest teilweise in der Öffnung 4 der Passivierungsschicht 5 angeordnet und die metallische Kontaktstruktur 3 ist durch die Öffnung 4 hindurch mit der Außenkontaktierung 6 verbunden. Dadurch kann der Grundkörper 2 über die metallische Kontaktstruktur 3 durch die Außenkontaktierung 6 elektrisch kontaktiert werden.

Auf der Außenkontaktierung 6 ist eine flexible Metallkompositschicht 7, die ein mit einem Metall gefülltes Polymer aufweist, derart angeordnet, dass die Außenkontaktierung 6 von der flexiblen Metallkompositschicht 7 bedeckt und umschlossen ist. Die Außenkontaktierung 6 kann über die flexible Metallkompositschicht 7 von außen elektrisch kontaktiert werden. Mittels der flexiblen Metallkompositschicht 7 gelingt es, dass Rissbildungen, die insbesondere an Verbindungsstellen zwischen der den Grundköper 2 umgebenden Passivierungsschicht 5 und der Metallkompositschicht 7 aufgrund von thermischen Spannungen auftreten können, vermieden werden können.

Des Weiteren ist auf der flexiblen Metallkompositschicht 7 in Bereichen, die nicht mit der Passivierungsschicht 5 und der Außenkontaktierung 6 in Berührung stehen, eine erste Schutzschicht 8 aus Nickel aufgebracht, die die flexible Metallkompositschicht 7 vor chemischen und/oder mechanischen Einflüssen schützt. Alternativ kann die erste Schutzschicht 8 auch andere oder weitere Materialien, wie zum Beispiel Kupfer oder Silber-Palladium, aufweisen. Auf der ersten Schutzschicht 8 ist eine zweite Schutzschicht 9 aus Zinn angeordnet, die für die erste Schutzschicht 8 als Oxidationsschutz dient. Die zweite Schutzschicht 9 kann ebenfalls andere und/oder weitere Materialien, wie zum Beispiel Gold oder einen organischen Oberflächenschutz, aufweisen.

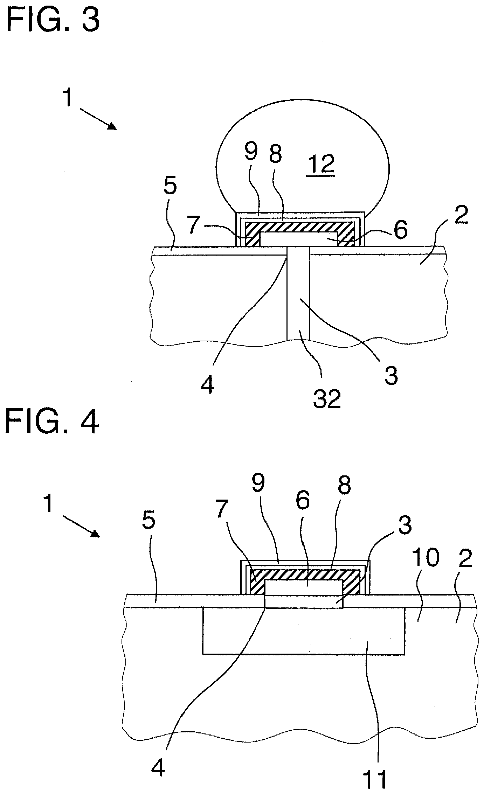

Figur 3 zeigt eine schematische Ansicht eines Ausschnittes eines elektrischen Bauelements 1 gemäß einem weiteren Ausführungsbeispiel, das als Keramikkörper mit Via ausgebildet ist. Das elektrische Bauelement 1 weist einen Grundkörper 2 aus Aluminiumoxid auf, in dem eine metallische Kontaktstruktur 3 angeordnet ist. Die metallische Kontaktstruktur 3 ist als ein mit einem Metall, beispielsweise mit Silber, gefülltes Via 32 ausgebildet, welches sich in den Grundkörper 2 hinein erstreckt.

Weiterhin weist das elektrische Bauelement 1 eine elektrisch isolierende Passivierungsschicht 5 aus Glas auf, die direkt auf den Grundkörper 2 aufgebracht ist und eine Öffnung 4 aufweist. Alternativ zum gezeigten Ausführungsbeispiel kann die elektrisch isolierende Passivierungsschicht 5 auch ein Keramikmaterial aufweisen. Das Via 32 erstreckt sich mit seinem einen Ende durch die Öffnung 4 der Passivierungsschicht 5 hindurch und ist mit einer Außenkontaktierung 6 direkt verbunden, die als Silberpad ausgebildet ist und direkt auf der Passivierungsschicht 5 angeordnet ist, wobei die Außenkontaktierung 6 die Öffnung 4 bedeckt. Somit ist die metallische Kontaktstruktur 3 durch die Öffnung 4 hindurch mit der Außenkontaktierung 6 verbunden.

Die Außenkontaktierung ist von einer flexiblen Metallkompositschicht 7 bedeckt und umschlossen. Im gezeigten Ausführungsbeispiel weist die flexible Metallkompositschicht 7 ein Polymer auf, das mit Silber versetzt ist. Alternativ kann das Polymer auch mit anderen und/oder weiteren Metallen versetzt sein.

Auf der flexiblen Metallkompositschicht 7 ist eine Lotkugel 12 angeordnet, mittels der eine Leiterplatte oder andere elektrische Bauelemente, wie zum Beispiel eine LED ("lightemitting diode", Leuchtdiode) angebunden werden können. Die Lotkugel 10 weist im gezeigten Ausführungsbeispiel ein Zinn-Silber-Kupfer-Lot auf. Alternativ sind auch andere Lotmaterialien möglich.

Das elektrische Bauelement 1 kann auch weitere Außenkontaktierungen (nicht gezeigt) aufweisen, die mit weiteren metallischen Vias verbunden sind und jeweils von flexiblen Metallkompositschichten bedeckt sind. Dadurch entsteht eine sogenannte Kugelgitteranordnung (BGA, "ball grid array"), bei der die Anschlüsse als Lotkugeln ausgebildet sind und für eine SMD-Bestückung auf einer Seite des elektrischen Bauelements liegen. Die Lotkugeln werden mittels Reflow-Löten in einem Lötofen aufgeschmolzen und verbinden sich mit Kontaktpads eines Trägers, einer Leiterplatte oder eines anderen elektrischen Bauelements.

Durch die Metallkompositschicht 7 auf den Außenkontaktierungen 6 können Spannungen, die während oder nach dem Löten auftreten, wirksam kompensiert werden.

Alternativ ist es auch möglich, dass das elektrische Bauelement 1 anstelle eines "Ball Grid Arrays" als Anschlüsse an einen Träger, eine Leiterplatte oder an ein anderen elektrisches Bauelement ein sogenanntes "Land Grid Array" aufweist, bei dem die Anschlüsse in Form eines schachbrettartigen Feldes von Kontaktflächen ausgeführt sind.

In Figur 4 ist ein Ausschnitt eines Querschnittes eines elektrischen Bauelements 1 gemäß einem weiteren Ausführungsbeispiel dargestellt, wobei das elektrische Bauelement 1 als Halbleiterbauelement ausgeführt ist. Das elektrische Bauelement 1 weist einen Grundköper 2 aus Silizium auf. Alternativ sind auch andere halbleitende Materialien möglich. Der Grundkörper 2 umfasst einen n-dotierten Bereich mit einer eindiffundierten p-dotierten Wanne 11. Weiterhin weist das elektrische Bauelement 1 eine elektrisch isolierende Passivierungsschicht 5 auf, die unmittelbar auf den Grundkörper 2 aufgebracht ist und Glas aufweist. Alternativ dazu kann die Passivierungsschicht 5 auch ein Keramikmaterial aufweisen oder daraus bestehen. Die Passivierungsschicht 5 weist eine Öffnung 4 auf. Im Bereich der Öffnung 4 ist der Grundkörper 2 nicht von der Passivierungsschicht 5 bedeckt.

Eine metallische Kontaktstruktur 3, die als Kupferkathode ausgebildet ist, ist in der Öffnung 4 angeordnet und steht mit der p-Wanne 11 in direktem Kontakt. Alternativ zum gezeigten Ausführungsbeispiel, bei dem die metallische Kontaktstruktur 3 ganz in der Öffnung 4 angeordnet ist, kann die metallische Kontaktstruktur 3 auch teilweise aus der Öffnung herausreichen und auf einem Teilbereich der Passivierungsschicht 5 angeordnet sein. Auf der metallischen Kontaktstruktur 3 ist eine als Kupferpad ausgebildete Außenkontaktierung 6 aufgebracht. Die Außenkontaktierung 6 ist ebenfalls in der Öffnung 4 der Passivierungsschicht 5 angeordnet.

Des Weiteren ist eine flexible Metallkompositschicht 7 auf der Außenkontaktierung 6 und auf Teilbereichen der Passivierungsschicht 5 angeordnet, so dass die flexible Metallkompositschicht 7 die Außenkontaktierung 6 bedeckt und umschließt. Die flexible Metallkompositschicht 7 weist ein mit Kupfer versetztes Polymer auf. Alternativ zum gezeigten Ausführungsbeispiel kann das Polymer auch mit weiteren und/oder anderen Metallen versetzt sein.

Das elektrische Bauelement 1 kann weitere Außenkontaktierungen auf metallischen Kontaktstrukturen aufweisen, die jeweils von einer flexiblen Metallkompositschicht umschlossen sind. Dadurch entsteht eine als "Land Grid Array" bezeichnete Terminierung. Alternativ ist auch eine "Ball Grid Array"-Terminierung mit Lötkugeln, wie im Ausführungsbeispiel der Figur 3 gezeigt, möglich.

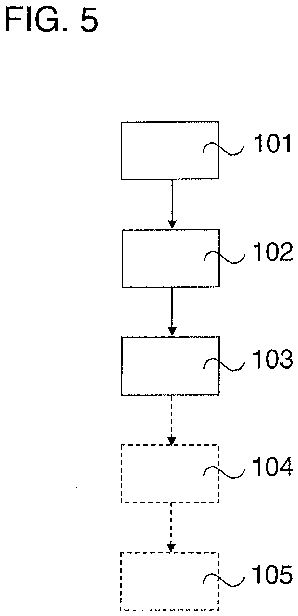

In Figur 5 ist eine Darstellung von Verfahren zur Herstellung eines elektrischen Bauelements 1 gemäß weiteren Ausführungsbeispielen gezeigt. Beispielsweise kann mittels des gezeigten Verfahrens ein elektrisches Bauelement 1 gemäß einem der Ausführungsbeispiele der Figuren 1 bis 4 herstellbar sein. Die folgenden Verweise auf Merkmale des elektrischen Bauelements 1 können sich daher auf Elemente der Figuren 1 bis 4 unter Verwendung der dort gezeigten Bezugszeichen beziehen.

In einem ersten Verfahrensschritt 101 wird ein Grundkörper 2 bereitgestellt. Der Grundkörper 2 ist mit einer unmittelbar mit dem Grundkörper 2 in Kontakt stehenden metallischen Kontaktstruktur 3 sowie vorzugsweise mit einer elektrisch isolierenden Passivierungsschicht 5 auf seinen Außenflächen versehen. Wie bereits im Zusammenhang mit den Figuren 1 bis 4 beschrieben, kann die metallische Kontaktstruktur 3 beispielsweise als Metallpad, als metallisches Via 32 oder als eine oder mehrere metallische Innenelektroden 31 ausgebildet sein und durch zumindest eine Öffnung 4 der Passivierungsschicht 5 durch diese hindurchragen. Die elektrisch isolierende Passivierungsschicht 5 weist vorzugsweise ein Glas- oder ein Keramikmaterial auf.

In einem zweiten Verfahrensschritt 102 wird anschließend eine Außenkontaktierung 6 auf den Grundkörper 2 aufgebracht. Die Außenkontaktierung 6 wird zum Beispiel als Metallpaste mittels Siebdruck aufgebracht. Alternativ kann die Außenkontaktierung 6 auch durch Sputtern oder durch einen Tauchprozess auf den Grundkörper 2 aufgebracht werden. Nach dem Aufbringen der Außenkontaktierung 6 steht die Außenkontaktierung 6 vorzugsweise mit der metallischen Kontaktstruktur 3 in unmittelbarem Kontakt.

Nachfolgend wird in einem dritten Verfahrensschritt 103 eine flexible Metallkompositschicht 7 auf die Außenkontaktierung 6 und/oder auf Bereiche der Passivierungsschicht 5 aufgebracht, beispielsweise in Form einer Polymerpaste, die mit Metallpartikeln, zum Beispiel mit Metallpartikeln unterschiedlicher Form und Größe, versehen ist. Die Metallkompositschicht 7 wird mittels Siebdruck oder mittels eines Tauchprozesses aufgebracht. Dabei ist die Außenkontaktierung 6 nach dem Aufbringen der flexiblen Metallkompositschicht 7 von der Metallkompositschicht 7 bedeckt und umschlossen.

Weiterhin ist es möglich, dass zwischen dem zweiten Verfahrensschritt 102 und dem dritten Verfahrensschritt 103 und/oder unmittelbar nach dem dritten Verfahrensschritt 103 eine thermische Behandlung durchgeführt wird. Eine zwischen den Verfahrensschritten 102 und 103 durchgeführte thermische Behandlung kann zum Beispiel über einen Zeitraum von etwa 10 Minuten bis etwa 60 Minuten und bei einer Temperatur von etwa 500°C bis etwa 1000°C durchgeführt werden. Eine sich an den Verfahrensschritt 103 unmittelbar anschließende thermische Behandlung kann beispielsweise über einen Zeitraum von etwa 10 Minuten bis etwa 120 Minuten und bei einer Temperatur von etwa 100°C bis etwa 250°C durchgeführt werden.

Gemäß einem weiteren Ausführungsbeispiel kann sich an den Verfahrensschritt 103 ein weiterer Verfahrensschritt 104 anschließen, der in Figur 5 gestrichelt angedeutet ist und bei dem auf die flexible Metallkompositschicht 7 eine erste Schutzschicht 8 aufgebracht wird. Die erste Schutzschicht 8 wird beispielsweise mittels Elektroplattieren aufgebracht. Alternativ kann die erste Schutzschicht 8 mittels Sputtern aufgebracht werden. Die erste Schutzschicht 8 kann zum Beispiel Nickel, Kupfer oder Silber-Palladium aufweisen oder daraus bestehen. Vorzugsweise dient sie dem Schutz der flexiblen Metallkompositschicht 7 vor chemischen und/oder mechanischen Einflüssen.

Weiterhin kann auf den Verfahrensschritt 104 gemäß noch einem weiteren Ausführungsbeispiel ein weiterer Verfahrensschritt 105 folgen, der ebenfalls gestrichelt angedeutet ist und bei dem auf die erste Schutzschicht 8 eine zweite Schutzschicht 9, beispielsweise wiederum mittels Elektroplattieren oder Sputtern, aufgebracht wird. Die zweite Schutzschicht 9 kann zum Beispiel Zinn, Gold oder ein OSP-Material aufweisen oder daraus bestehen. Vorzugsweise schützt die zweite Schutzschicht 9 erste Schutzschicht 8 vor Oxidation.

Die in Verbindung mit der Figur 5 beschriebenen Verfahren zur Herstellung eines elektrischen Bauelements zeichnen sich dadurch aus, dass sie im Vergleich zu bekannten Verfahren ohne großen zusätzlichen Aufwand erfolgen können.

Die Erfindung ist nicht durch die Beschreibung anhand der Ausführungsbeispiele auf diese beschränkt.

### Bezugszeichenliste

- 1: elektrisches Bauelement
- 2: Grundkörper
- 3: metallische Kontaktstruktur
- 31: Innenelektrode
- 32: metallisches Via
- 4: Öffnung
- 5: Passivierungsschicht
- 6: Außenkontaktierung
- 7: flexible Metallkompositschicht
- 8: erste Schutzschicht
- 9: zweite Schutzschicht
- 10, 11: dotierte Bereiche
- 12: Lotkugel
- 101, 102, 103, 104, 105: Verfahrensschritt

## Patentansprüche

1. Elektrisches Bauelement (1) aufweisend einen Grundkörper (2), eine metallische Kontaktstruktur (3), die unmittelbar mit dem Grundkörper (2) in Kontakt steht, und eine mit einer Öffnung (4) versehene, elektrisch isolierende Passivierungsschicht (5), wobei die metallische Kontaktstruktur (3) durch die Öffnung (4) hindurch mit einer Außenkontaktierung (6) verbunden ist, wobei die Außenkontaktierung (6) von einer flexiblen Metallkompositschicht (7) bedeckt und umschlossen ist, wobei die metallische Kontaktstruktur (3) mittels der flexiblen Metallkompositschicht (7) über die Außenkontaktierung (6) von außen elektrisch kontaktierbar ist, wobei das Bauelement zur Verlötung ausgebildet ist und die flexible Metallkompositschicht (7) zur Reduzierung von über ein Lot ausgeübten Spannungen ausgebildet ist, wobei die Metallkompositschicht (7) vom Grundkörper (2) aus gesehen auf Teilbereichen der Passivierungsschicht (5) aufgebracht ist.

2. Elektrisches Bauelement (1) nach Anspruch 1, wobei die Außenkontaktierung (6) zumindest teilweise auf der Passivierungsschicht (5) aufgebracht ist.

3. Elektrisches Bauelement (1) nach Anspruch 1, wobei die Außenkontaktierung (6) in der Öffnung (4) angeordnet ist.

4. Elektrisches Bauelement (1) nach einem der vorherigen Ansprüche, wobei die flexible Metallkompositschicht (7) in direktem Kontakt mit Teilbereichen der Passivierungsschicht (5) steht.

5. Elektrisches Bauelement (1) nach einem der vorherigen Ansprüche, wobei die metallische Kontaktstruktur (3) in den Grundkörper (2) hineinragt.

6. Elektrisches Bauelement (1) nach Anspruch 5, wobei die metallische Kontaktstruktur (3) zumindest eine Innenelektrode (31) aufweist oder als metallisches Via (32) ausgeführt ist.

7. Elektrisches Bauelement (1) nach einem der Ansprüche 1 bis 4, wobei die metallische Kontaktstruktur (3) auf einer Oberfläche des Grundkörpers (2) aufgebracht ist und wobei die Außenkontaktierung (6) den Grundkörper (2) über die metallische Kontaktstruktur (3) elektrisch kontaktiert.

8. Elektrisches Bauelement (1) nach einem der vorherigen Ansprüche, wobei der Grundkörper (2) ein Keramikmaterial und/oder ein Halbleitermaterial aufweist.

9. Elektrisches Bauelement (1) nach einem der vorherigen Ansprüche, wobei die Passivierungsschicht (5) Glas und/oder ein keramisches Material aufweist.

10. Elektrisches Bauelement (1) nach einem der vorherigen Ansprüche, wobei die flexible Metallkompositschicht (7) ein Kunststoffmaterial, insbesondere ein Polymer, aufweist.

11. Elektrisches Bauelement (1) nach einem der vorherigen Ansprüche, wobei auf der dem Grundkörper (2) abgewandten Seite der flexiblen Metallkompositschicht (7) eine erste Schutzschicht (8) angeordnet ist.

12. Elektrisches Bauelement (1) nach Anspruch 11, wobei auf der ersten Schutzschicht (8) eine zweite Schutzschicht (9) angeordnet ist.

13. Elektrisches Bauelement (1) nach Anspruch 12, wobei die erste Schutzschicht (8) Nickel und die zweite Schutzschicht (9) Zinn aufweist.

14. Verfahren zur Herstellung eines elektrischen Bauelements (1) gemäß einem der Ansprüche 1 bis 13 aufweisend die folgenden Schritte:
- Bereitstellen des Grundkörpers (2), der mit der metallischen Kontaktstruktur (3) sowie der elektrisch isolierenden Passivierungsschicht (5) versehen ist,
- Aufbringen der Außenkontaktierung (6) auf den Grundkörper (2) mittels Siebdruck, mittels Sputtern oder mittels eines Tauchprozesses, so dass die Außenkontaktierung (6) mit der metallischen Kontaktstruktur (3) in elektrischem Kontakt steht, und
- Aufbringen der flexiblen Metallkompositschicht (7) mittels Siebdruck oder mittels eines Tauchprozesses, so dass die Außenkontaktierung (6) von der flexiblen Metallkompositschicht (7) bedeckt und umschlossen ist und so dass die Metallkompositschicht (7) Teilbereiche der Passivierungsschicht (5) bedeckt.

15. Verfahren nach Anspruch 14, wobei nach dem Aufbringen der Außenkontaktierung (6) und/oder nach dem Aufbringen der flexiblen Metallkompositschicht (7) eine thermische Behandlung durchgeführt wird.

## Claims

1. Electrical component (1) comprising a main body (2), a metallic contact structure (3), which is directly in contact with the main body (2), and an electrically insulating passivation layer (5) provided with an opening (4), wherein the metallic contact structure (3) is connected to an external contact-making means (6) through the opening (4), wherein the external contact-making means (6) is covered and enclosed by a flexible metal composite layer (7) wherein electrical contact is able to be made with the metallic contact structure (3) externally by means of the flexible metal composite layer (7) by way of the external contact-making means (6), wherein the component is configured for soldering and the flexible metal composite layer (7) is configured for reducing stresses exerted by way of a solder, wherein the metal composite layer (7) is applied on partial regions of the passivation layer (5), as viewed from the main body (2).

2. Electrical component (1) according to Claim 1, wherein the external contact-making means (6) is at least partly applied on the passivation layer (5).

3. Electrical component (1) according to Claim 1, wherein the external contact-making means (6) is arranged in the opening (4).

4. Electrical component (1) according to any of the preceding claims, wherein the flexible metal composite layer (7) is in direct contact with partial regions of the passivation layer (5).

5. Electrical component (1) according to any of the preceding claims, wherein the metallic contact structure (3) projects into the main body (2).

6. Electrical component (1) according to Claim 5, wherein the metallic contact structure (3) has at least one internal electrode (31) or is embodied as a metallic via (32).

7. Electrical component (1) according to any of Claims 1 to 4, wherein the metallic contact structure (3) is applied on a surface of the main body (2), and wherein the external contact-making means (6) makes electrical contact with the main body (2) by means of the metallic contact structure (3) .

8. Electrical component (1) according to any of the preceding claims, wherein the main body (2) comprises a ceramic material and/or a semiconductor material.

9. Electrical component (1) according to any of the preceding claims, wherein the passivation layer (5) comprises glass and/or a ceramic material.

10. Electrical component (1) according to any of the preceding claims, wherein the flexible metal composite layer (7) comprises a plastic material, in particular a polymer.

11. Electrical component (1) according to any of the preceding claims, wherein a first protective layer (8) is arranged on that side of the flexible metal composite layer (7) which faces away from the main body (2) .

12. Electrical component (1) according to Claim 11, wherein a second protective layer (9) is arranged on the first protective layer (8).

13. Electrical component (1) according to Claim 12, wherein the first protective layer (8) comprises nickel and the second protective layer (9) comprises tin.

14. Method for producing an electrical component according to any of Claims 1 to 13 comprising the following steps:
- providing the main body (2), which is provided with the metallic contact structure (3) and the electrically insulating passivation layer (5),
- applying the external contact-making means (6) to the main body (2) by means of screen printing, by means of sputtering or by means of a dip process, such that the external contact-making means (6) is in electrical contact with the metallic contact structure (3), and
- applying the flexible metal composite layer (7) by means of screen printing or by means of a dip process, such that the external contact-making means (6) is covered and enclosed by the flexible metal composite layer (7) and such that the metal composite layer (7) covers partial regions of the passivation layer (5).

15. Method according to Claim 14, wherein a thermal treatment is carried out after applying the external contact-making means (6) and/or after applying the flexible metal composite layer (7).

## Revendications

1. Composant électrique (1) comportant un corps de base (2), une structure de contact métallique (3) qui est en contact direct avec le corps de base (2), et une couche de passivation électriquement isolante (5) pourvue d'une ouverture (4), la structure de contact métallique (3) étant reliée à travers l'ouverture (4) à un contact extérieur (6), le contact extérieur (6) étant recouvert et entouré par une couche composite métallique souple (7), la structure de contact métallique (3) pouvant être amenée en contact électrique depuis l'extérieur au moyen de la couche composite métallique souple (7) par le biais du contact extérieur (6), le composant étant conçu pour être soudé et la couche composite métallique souple (7) étant conçue pour réduire les contraintes exercées par le biais d'une soudure, la couche composite métallique (7) étant appliquée, vue depuis le corps de base (2), sur des zones de la couche de passivation (5).

2. Composant électrique (1) selon la revendication 1, le contact extérieur (6) étant appliqué au moins partiellement sur la couche de passivation (5).

3. Composant électrique (1) selon la revendication 1, le contact extérieur (6) étant disposé dans l'ouverture (4) .

4. Composant électrique (1) selon l'une des revendications précédentes, la couche composite métallique souple (7) étant en contact direct avec des zones de la couche de passivation (5).

5. Composant électrique (1) selon l'une des revendications précédentes, la structure de contact métallique (3) faisant saillie dans le corps de base (2) .

6. Composant électrique (1) selon la revendication 5, la structure de contact métallique (3) comportant au moins une électrode intérieure (31) ou étant réalisée sous la forme d'un passage métallique (32).

7. Composant électrique (1) selon l'une des revendications 1 à 4, la structure de contact métallique (3) étant appliquée sur une surface du corps de base (2) et le contact extérieur (6) étant amené en contact électrique avec le corps de base (2) par le biais de la structure de contact métallique (3).

8. Composant électrique (1) selon l'une des revendications précédentes, le corps de base (2) comportant une matière céramique et/ou un matériau semi-conducteur.

9. Composant électrique (1) selon l'une des revendications précédentes, la couche de passivation (5) comportant du verre et/ou une matière céramique.

10. Composant électrique (1) selon l'une des revendications précédentes, la couche composite métallique souple (7) comportant une matière synthétique, en particulier un polymère.

11. Composant électrique (1) selon l'une des revendications précédentes, une première couche de protection (8) étant disposée sur le côté de la couche composite métallique souple (7) qui est dirigé à l'opposé du corps de base (2).

12. Composant électrique (1) selon la revendication 11, une deuxième couche de protection (9) étant disposée sur la première couche de protection (8).

13. Composant électrique (1) selon la revendication 12, la première couche de protection (8) comportant du nickel et la deuxième couche de protection (9) comportant de l'étain.

14. Procédé de réalisation d'un composant électrique (1) selon l'une des revendications 1 à 13, ledit procédé comportant les étapes suivantes :
- fournir le corps de base (2) qui est pourvu de la structure de contact métallique (3) et de la couche de passivation électriquement isolante (5),
- appliquer le contact extérieur (6) sur le corps de base (2) par sérigraphie, pulvérisation cathodique ou un processus d'immersion de sorte que le contact extérieur (6) soit en contact électrique avec la structure de contact métallique (3), et
- appliquer la couche composite métallique souple (7) par sérigraphie ou un processus d'immersion de sorte que le contact extérieur (6) soit recouvert et entouré par la couche composite métallique souple (7) et de sorte que la couche composite métallique (7) recouvre des zones de la couche de passivation (5).

15. Procédé selon la revendication 14, un traitement thermique étant effectué après l'application du contact extérieur (6) et/ou après l'application de la couche composite métallique souple (7).
